# FASCICULE DE BREVET EUROPEEN

(11) **EP 2 189 770 B1**
(45) Date de publication et mention de la délivrance du brevet: **30.03.2011**
(21) Numéro de dépôt: 09176262.5
(22) Date de dépôt: 17.11.2009
(51) Int. Cl.: G01J 5/02, G01J 5/04, H01L 21/56, H01L 27/148

(54) **Système détecteur avec fonction optique et procédé de réalisation d'un tel système**
Detektorvorrichtung mit optischer Funktion und deren Herstellungsverfahren
Detector system with optical function and fabrication method thereof

(30) Priorité: 19.11.2008 FR 0857856
(43) Date de publication de la demande: 26.05.2010
(73) Titulaire: Commissariat à l'Énergie Atomique et aux Énergies Alternatives, 75015 Paris (FR)
(72) Inventeur: Fendler, Manuel, 38000, GRENOBLE (FR); Lasfargues, Gilles, 38000, GRENOBLE (FR); Marion, François, 38950, SAINT-MARTIN LE VINOUX (FR)
(74) Mandataire: Ilgart, Jean-Christophe

(56) Documents cités:
- EP-A1- 0 662 721
- FR-A1- 2 780 200

## Description

### DOMAINE TECHNIQUE

L'invention concerne un système détecteur avec fonction optique et un procédé de réalisation de celui-ci.

### ÉTAT DE LA TECHNIQUE ANTÉRIEURE

Le domaine de l'invention est celui des détecteurs de rayonnement électromagnétique, plus particulièrement des détecteurs infrarouge refroidis, et le positionnement d'au moins un élément optique, par exemple d'une matrice de microlentilles, d'un système de zoom, etc., au plus près d'un de ces détecteurs, par exemple à une distance de 0 à quelques centaines de micromètres.

### - les détecteurs infrarouge refroidis

Un détecteur infrarouge (IR) refroidi peut être obtenu par l'association d'un matériau sensible aux rayonnements infrarouge, qui transforme les photons reçus en électrons, et d'un circuit de lecture, qui permet le traitement de ces électrons pour former une image. La qualité des images fournies par un tel détecteur dépend du nombre de pixels qui le constitue et de l'environnement dans lequel il se trouve. Le nombre de pixels est déterminé par le nombre de connexions électriques entre le matériau photosensible et le circuit de lecture. Les détecteurs infrarouge actuels peuvent comporter une centaine de milliers de pixels au pas de 10 à 50 µm pour une surface active de 1 à 2cm².

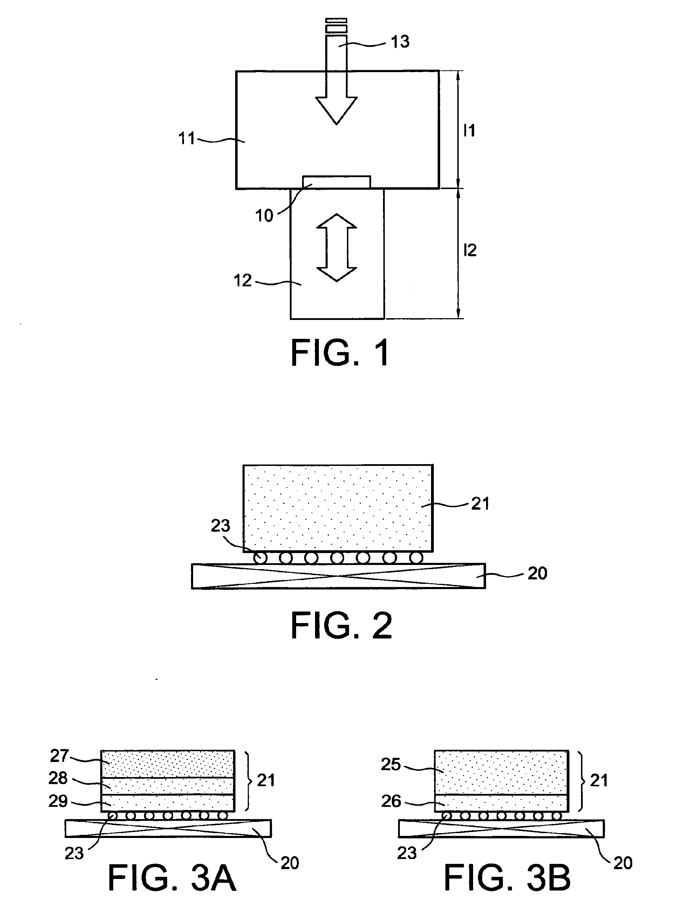

Pour diminuer le bruit dans un détecteur, on peut confiner celui-ci dans un cryostat sous vide, par exemple à une température de 77 Kelvin (environ - 200°C). Les cryostats et leurs systèmes de refroidissements déterminent la taille des systèmes de détection infrarouge. Dans une vue en coupe d'un détecteur infrarouge 10 dans son cryostat, illustrée sur la figure 1, sont ainsi représentés :
- le détecteur 10 du rayonnement infrarouge 13,
- la chambre sous vide 11 du cryostat, de longueur 1₁ (10 cm < 1₁ < 20 cm),
- un système 12 de refroidissement du détecteur de longueur 1₂ (10 cm < 1₂ < 20 cm).

On obtient un détecteur infrarouge refroidi en mettant en oeuvre une technique dite d'hybridation par billes, appelée en anglais « flip chip », et décrite dans le document référencé [1] en fin de description. Cette technique d'hybridation, illustrée sur la figure 2, permet de relier mécaniquement et électriquement un circuit de lecture 20 et une partie détectrice ou détecteur 21, au moyen de billes d'hybridation 23, encore appelées billes de connexion électrique, dont la hauteur est de l'ordre de 10 µm pour un détecteur actuel au pas de 30 µm et augmente avec le pas des pixels.

La partie détectrice 21 peut être constituée de deux matériaux (« homo-substrat ») pour former un substrat 25 (environ 500 µm) et une partie active 26 (environ 10 µm) comme illustré sur la figure 3B, soit de trois matériaux (« hétéro-substrat ») pour former un substrat 27 (environ 500 µm), un substrat intermédiaire 28 (de quelques µm à quelques 10 µm) et une partie active 29 (environ 10 µm) comme illustré sur la figure 3A. L'état de l'art en ce qui concerne les détecteurs de rayonnement infrarouge sur substrat CdZNTe ou CdTe est décrit dans le document référencé [2]. Dans la suite on considère des détecteurs homo-substrat à titre d'exemple. Cependant les deux types de détecteurs sont possibles.

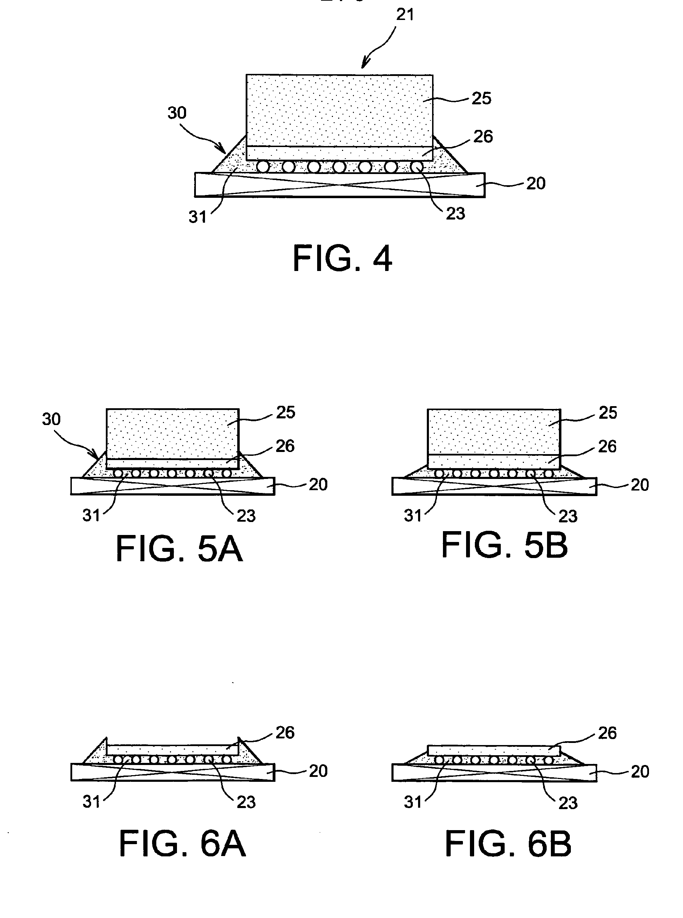

Ainsi, dans le domaine de la détection des rayonnements infrarouge, les détecteurs doivent fonctionner à basses températures afin de minimiser les bruits de fond qui se superposent au signal à détecter. Pour minimiser les risques de rupture mécanique et électrique des billes de connexion 23 lors de la mise à froid du détecteur, une technique de l'art connu consiste à mettre en place un matériau de remplissage ou « underfill » 31 entre le circuit de lecture 20 et la partie détectrice 21, en déposant par exemple des gouttes d'époxy sur le circuit de lecture afin que 1'« underfill » pénètre entre les billes 23 et comble l'espace entre le circuit de lecture 20 et la partie détectrice 21. La mise en place de cet « underfill » peut être faite avant ou après l'hybridation des composants, comme décrit dans le document référencé [3]. Dans les deux cas, les matériaux utilisés pour l'« underfill » remontent par capillarité sur les côtés de la partie détectrice 21, comme illustré sur la figure 4, et créent un bourrelet 30. Plus précisément, un tel bourrelet 30 se forme lorsque le matériau de remplissage couvre les bords latéraux de la partie active. La hauteur, sur laquelle remonte l'« underfill », qui est de l'ordre de 200 µm peut être augmentée ou diminuée. On obtient ainsi deux configurations de détecteur possible : avec ou sans bourrelet, comme illustré respectivement sur les figures 5A et 5B.

Ces techniques de mise en place d'un « underfill » pour la minimisation des risques de ruptures des billes 23 peuvent être associées à un amincissement de la partie détectrice 21 qui peut être réalisé de façon chimique par chimie sélective sur les différents substrats, ou mécanique par polissage. Suivant la configuration d'« underfill » choisi, avec ou sans bourrelet, on obtient, après un tel amincissement, deux formes de détecteur possible, comme illustré sur les figures 6A et 6B. Pour des raisons mécaniques de pression du bourrelet sur le détecteur, la configuration la plus utilisée aujourd'hui est celle sans bourrelet, représentée sur la figure 6B. Cette figure illustre donc l'état de l'art pour les détecteurs infrarouge refroidis. Les documents FR2780200 et EP0662721 divulguent aussi des détecteurs infrarouge refroidis de l'état de l'art.

### - Les éléments optiques

Les éléments optiques, par exemple lentille, zoom, etc., utilisés sont développés par les équipementiers afin d'obtenir des détecteurs infrarouge multifonctions. Ces éléments, placés en dehors du cryostat, augmentent la taille du système complet formé par le cryostat, le système de refroidissement et les éléments optiques, ainsi que son poids.

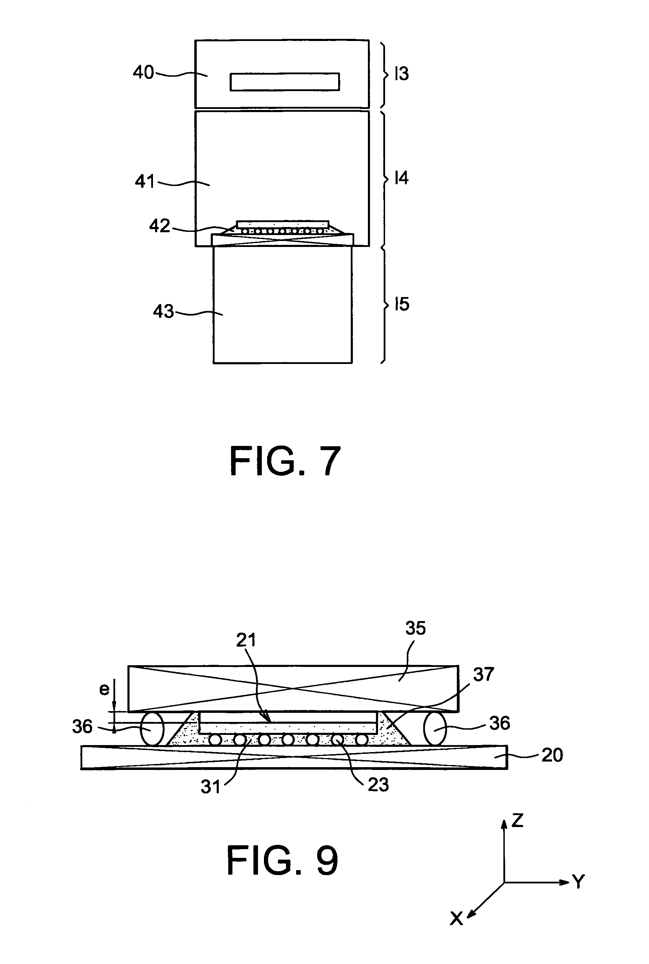

La figure 7 illustre ainsi un détecteur avec fonction optique de l'art antérieur, comprenant un bloc optique 40 de longueur 1₃, un cryostat 41 de longueur 1₄, un détecteur 42 du type illustré sur la figure 6B, un système de refroidissement 43 de longueur 1₅.

On a classiquement :
0 <1₃ < 30cm
~10 cm < 1₄ < 20 cm
~10 cm < 1₅ < 20 cm

Etant donné la miniaturisation des éléments optiques, leur taille (surface d'environ 1 cm²) ainsi que leur distance de focalisation, et des détecteurs électromagnétiques, les systèmes de positionnement actuels ne répondent plus à des exigences de positionnement et d'alignement de l'ordre de quelques micromètres entre élément optique et détecteur.

L'invention a pour objet de résoudre un tel problème technique en proposant de nouveaux système et procédé de positionnement et d'alignement passif d'au moins un élément optique au plus près d'un détecteur de rayonnement électromagnétique.

### EXPOSÉ DE L'INVENTION

L'invention concerne un système détecteur avec fonction optique comprenant .Les caractéristiques de la revendication 1.

L'invention concerne également un procédé de réalisation d'un système détecteur avec fonction selon la revendication 4. optique

Dans un premier mode de réalisation, ce procédé comprend les étapes suivantes :
- une étape de fabrication d'un bourrelet,
- une étape d'amincissement mécanique du détecteur,
- une étape de gravure chimique sélective permettant de créer des cales de soutien,
- une étape de fixation de l'au moins un élément optique avec des billes de maintien positionnées autour du détecteur de façon individuelle ou collective.

Avantageusement, des billes de maintien peuvent servir de lien électrique entre l'élément optique et le circuit de lecture.

Dans un second mode de réalisation, ce procédé comprend les étapes suivantes :
- une étape de gravure de sillons à la périphérie du détecteur,
- une étape de singularisation du détecteur,
- une étape d'hybridation du détecteur sur un circuit de lecture par l'intermédiaire de billes de soutien,
- une étape de dépôt d'un « underfill » entre ces billes de soutien,
- une étape d'amincissement mécanique du détecteur,
- une étape d'amincissement chimique sélectif permettant de créer des cales de maintien,
- une étape de fixation de l'élément optique.

Avantageusement, l'étape de fixation de l'élément optique comprend l'introduction de points ou d'un cordon de colle.

Dans un troisième mode de réalisation, ce procédé comprend les étapes suivantes :
- une étape d'épitaxie d'une couche active sur un substrat après réalisation d'un « buffer »,
- une étape d'hybridation,
- une étape d'amincissement mécanique, par exemple une étape de polissage maîtrisé quant à son arrêt à une côte déterminée,
- une première étape de gravure chimique,
- une étape de dépôt d'un cordon de résine périphérique,
- une seconde étape de gravure chimique,
- une étape d'élimination du cordon de résine par un solvant permettant d'obtenir une cale périphérique de soutien,
- une étape de dépôt d'au moins un élément optique avec des billes de maintien.

Grâce au système et au procédé de l'invention, le (ou les) élément(s) optique(s) peut (peuvent) être intégré(s) dans le cryostat, ce qui permet de diminuer considérablement la taille et le poids d'un détecteur de rayonnement électromagnétique multifonctions.

Le système et le procédé de l'invention présentent les avantages suivants:
- un contrôle en Z du positionnement de 0 à 800 µm de l'élément optique avec une tolérance inférieure à +/-10 µm,
- un alignement en X, Y et θ contrôlé avec une tolérance inférieure à +/-10 µm,
- une diminution, voire une annulation, des contraintes de poids sur les billes de connexion ou d'hybridation ou sur le détecteur et ainsi un positionnement au plus près du détecteur d'éléments optiques de poids conséquent,
- une augmentation de la fiabilité du détecteur grâce à un couplage robuste entre l'élément optique et le détecteur,
- une intégration de l'élément optique dans le cryostat.

De nombreuses applications industrielles sont possibles, par exemple :
- la mise en place de lentilles, réseaux de lentilles ou système de lentilles mobiles,
- la mise en place d'un système de fixation ou de centrage,
- la mise en place d'un module biologique miniaturisé.

Les détecteurs ainsi obtenus peuvent être utilisés pour de multiples applications : biologie, astronomie, médecine, etc.

### BRÈVE DESCRIPTION DES DESSINS

La figure 1 illustre une vue en coupe d'un détecteur infrarouge de l'art antérieur dans son cryostat.
La figure 2 illustre une vue en coupe d'un détecteur infrarouge de l'art antérieur assemblé par hybridation.
Les figures 3A et 3B illustrent deux configurations différentes d'un détecteur de l'art antérieur.
Les figures 4, 5A et 5B illustrent des vues en coupe d'un détecteur de l'art antérieur après mise en place d'un matériau de remplissage ou « underfill ».
Les figures 6A et 6B illustrent une vue en coupe d'un détecteur de l'art antérieur après amincissement suivant deux configurations possibles :
   avec bourrelet et sans bourrelet.
La figure 7 illustre un détecteur avec fonction optique de l'art antérieur.
Les figures 8A à 8C et 9 illustrent les étapes de fabrication d'un premier mode de réalisation du système de l'invention, ainsi que le dispositif final obtenu.
Les figures 10A à 10F, 11A à 11D et 12 illustrent les étapes de fabrication d'un second mode de réalisation du système de l'invention, ainsi que le dispositif final obtenu.
Les figures 13A à 13D, 14A à 14D et 15 illustrent les étapes de fabrication d'un troisième mode de réalisation du système de l'invention ainsi que le dispositif final obtenu.

### EXPOSE DETAILLE DE MODES DE REALISATION PARTICULIERS

Le système de l'invention est un système de positionnement et d'alignement passif, c'est-à-dire sans réglage pendant le positionnement, d'au moins un élément optique, par exemple des lentilles, zoom, etc., au plus près d'un détecteur, par exemple entre 0 et 800 µm. Dans ce système, on utilise des cales de soutien pour un positionnement en Z de l'élément optique au plus près du détecteur, et des moyens d'alignement en X et Y par le biais de cales et/ou billes de maintien, X, Y et Z étant des axes perpendiculaires entre eux comme illustré sur la figure 9.

Avantageusement, le détecteur est un détecteur infrarouge refroidi obtenu par un procédé de fabrication standard.

Grâce au système de l'invention, l'élément optique peut être intégré dans le cryostat, ce qui permet de diminuer considérablement la taille et le poids d'un détecteur de rayonnement électromagnétique multifonctions.

Le procédé de positionnement et d'alignement passif d'au moins un élément optique au plus près d'un détecteur de rayonnement électromagnétique selon l'invention comprend donc :
- une étape de formation de cales, par exemple à partir d'un bourrelet, de soutien pour le positionnement en Z de l'au moins un élément optique,
- une étape d'alignement passif en X et Y par le biais de cales et/ou billes de maintien.

Le procédé d'invention présente trois modes de réalisation.

### - Premier mode de réalisation

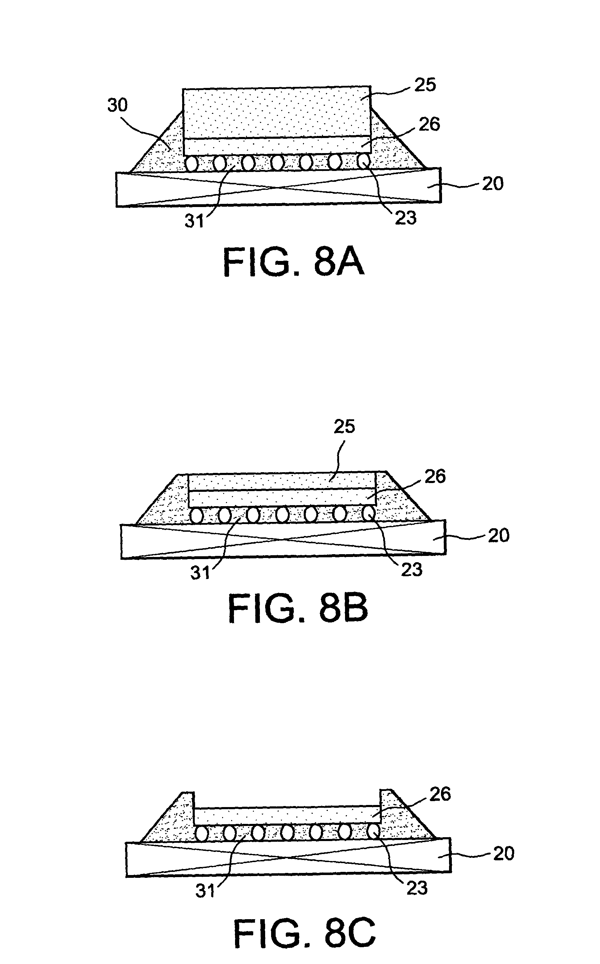

Ce premier mode de réalisation comprend :
- une étape de fabrication standard d'un bourrelet 30, par exemple de colle, comme illustré sur la figure 8A,
- une étape d'amincissement mécanique du détecteur comme illustré sur la figure 8B, en vue de la fixation d'au moins un élément optique 35 avec billage mécanique (billes de maintien 36).

Pour réaliser cet amincissement mécanique du détecteur jusqu'à la hauteur voulue (selon l'axe Z), on prend en compte la hauteur des billes d'hybridation ou de connexion 23 (environ 10 µm) , la hauteur de la partie détectrice 21 (environ 10 µm) et l'espace souhaité e entre la surface extérieure de la partie détectrice 21 et l'élément optique 35 (environ 20 µm) pour déterminer la hauteur (environ 40 µm) à laquelle l'amincissement mécanique doit être arrêté par rapport au circuit de lecture 20. On peut ainsi moduler cet espace e de quelques µm à quelques centaines de µm.

On réalise ensuite une étape de gravure chimique sélective, comme illustré sur la figure 8C, qui permet de graver le substrat 25 restant et de créer des cales de soutien 37 autour de la partie détectrice ou détecteur 21 avec le bourrelet 30, comme illustré sur la figure 8C. Ces cales de soutien 37 ont une hauteur d'environ 20 µm par rapport à la surface du détecteur et d'environ 40 µm par rapport au circuit de lecture 20.

On peut alors réaliser une étape de fixation de l'élément optique 35 avec billage mécanique comme illustré sur la figure 9 : des billes de maintien 36 sont ainsi positionnées de façon individuelle ou collective autour de la partie détectrice. Ces billes de maintien 36 sont formées dans un matériau souple. Elles permettent, en étant couplées avec une machine d'hybridation, l'auto-alignement en X et Y de l'élément optique 35 lors de l'hybridation. Cet auto-alignement se fait grâce aux forces de rappel liées à l'utilisation de billes, selon une énergie minimum. Ces billes de maintien 36 peuvent aussi servir de lien électrique entre l'élément optique 35 et le circuit de lecture 20, ce qui permet de positionner un élément optique actif.

Des cales de maintien, autres que des billes 36, peuvent être également utilisées pour un maintien mécanique externe ou un maintien par colle.

Ce premier mode de réalisation permet d'obtenir des avantages directs :
- positionnement en Z de quelques µm à quelques 100 µm avec une tolérance de +/-2.5 µm,
- alignement en X et Y grâce aux billes de maintien 36 à +/-0.1 µm,
- diminution de la contrainte de poids sur les billes de connexion ou d'hybridation 23.

Il permet également d'obtenir des avantages indirects :
- possibilité d'alimenter électriquement l'élément optique 35,
- possibilité d'herméticité, par exemple dans le cas où un maintien par colle est réalisé.

### - Second mode de réalisation

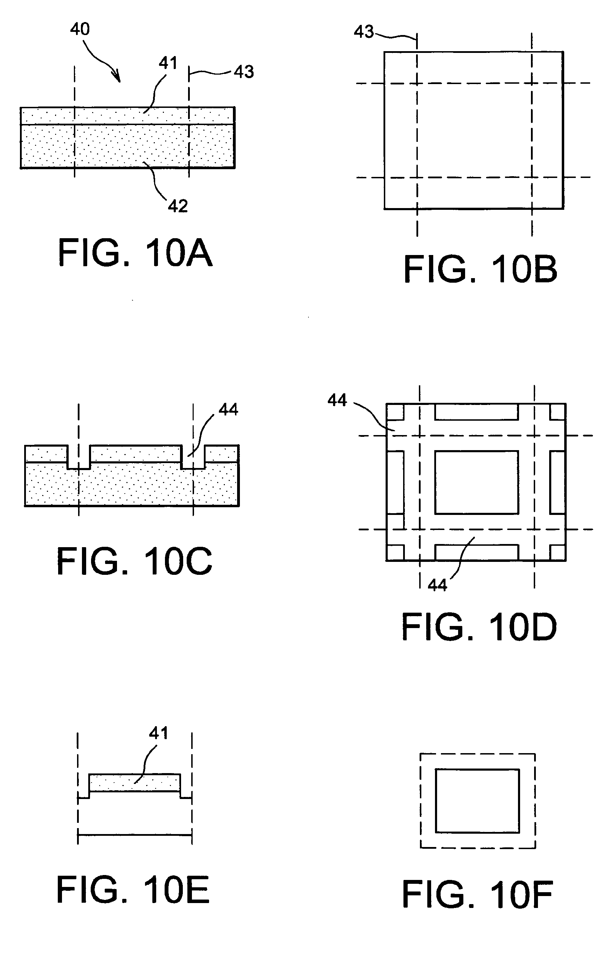

Ce second mode de réalisation comprend une étape de gravure de « sillons » 44 à la périphérie d'un détecteur 40 (par exemple selon deux directions orthogonales X et Y). Ce détecteur, illustré sur les figures 10A et 10B en vue en coupe et en vue de dessus (face hybridable en haut), comprend un substrat 42 et une partie active 41. Cette étape de gravure, qui peut être réalisée de plusieurs façons : gravure, plasma, etc., comme illustré sur les figures 10C et 10D, est alignée avec des lignes de découpe 43.

Les figures 10E et 10F illustrent une étape ultérieure de singularisation du détecteur (40) avant hybridation, le long des lignes de découpe 43.

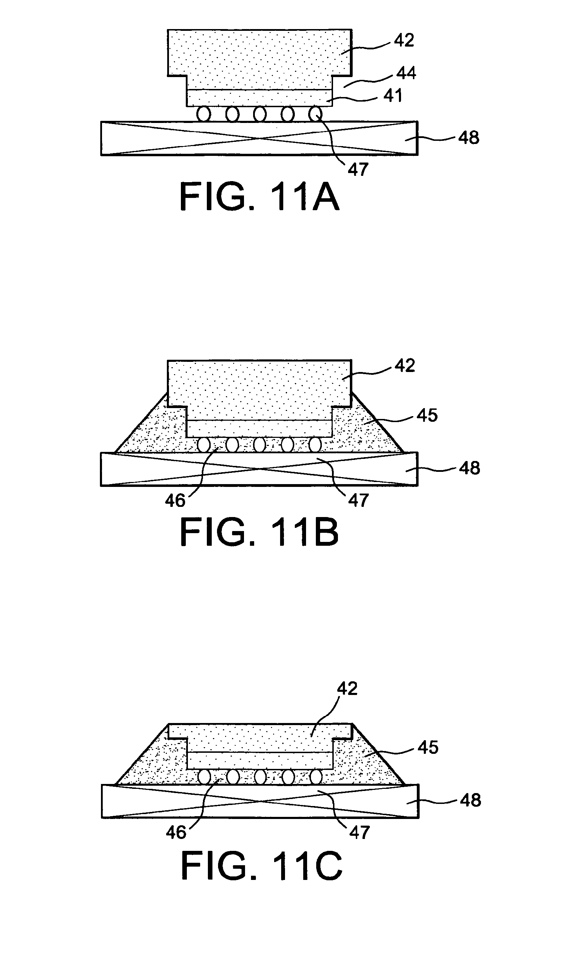

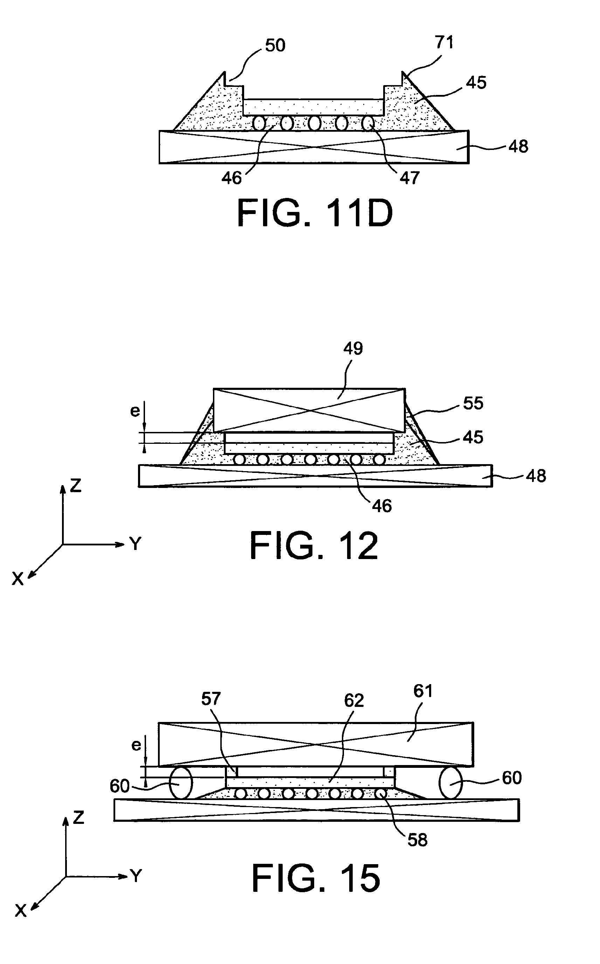

On récupère alors le détecteur (40) mis en forme, comme illustré sur les figures 10E et 10F et on l'hybride sur le circuit de lecture 48 selon la méthode « flip chip », comme illustré sur la figure 11A. Un matériau de remplissage ou « underfill » 46 est déposé entre les billes de connexion ou d'hybridation 47 sur le circuit de lecture 48 et remonte par capillarité sur les bords du détecteur remplissant le sillon formé dans ce détecteur comme illustré sur la figure 11B. Après polymérisation de l'« underfill » on réalise un amincissement mécanique classique du détecteur comme illustré sur la figure 11C. Après amincissement chimique sélectif, la forme 50 du sillon 44 apparait dans le bourrelet 45 comme illustré sur la figure 11D.

Le sillon 44 permet, par transfert de forme, de créer un support pour l'élément optique dans le bourrelet 45. Ainsi l'espace, par exemple environ 20 µm, entre l'élément optique et la surface du détecteur est directement défini par la profondeur du sillon environ 30 µm moins l'épaisseur du détecteur environ 10 µm.

Dans une étape de positionnement de l'élément optique 49, celui-ci vient se loger sur le support créé dans le bourrelet 30 comme illustré sur la figure 12, et peut être maintenu au support grâce à des points ou un cordon de colle 55 pour l'herméticité.

La forme 50 de sillon sert donc de support en Z pour l'élément optique 49. L'« underfill » 46 étant remonté par capillarité après avoir rempli le sillon 44, il se forme des cales de maintien 71 le long de la forme 50 du sillon 44 après amincissement chimique. Ces cales de maintien 71 permettent l'alignement en X et Y de l'élément optique 49.

Ce second mode de réalisation permet d'obtenir des avantages directs :
- positionnement e en Z de quelques µm a quelques 100 µm avec une tolérance de +/-2.5 µm,
- alignement en X et Y grâce aux cales de maintien 71 à +/-2.5 µm.

Il permet également d'obtenir des avantages indirects :
- lignes de découpe 43 de l'élément optique 49 et du détecteur 40 identiques,
- rapidité de fabrication,
- possibilité d'herméticité, par exemple au moyen d'un cordon de colle.

### - Troisième mode de réalisation

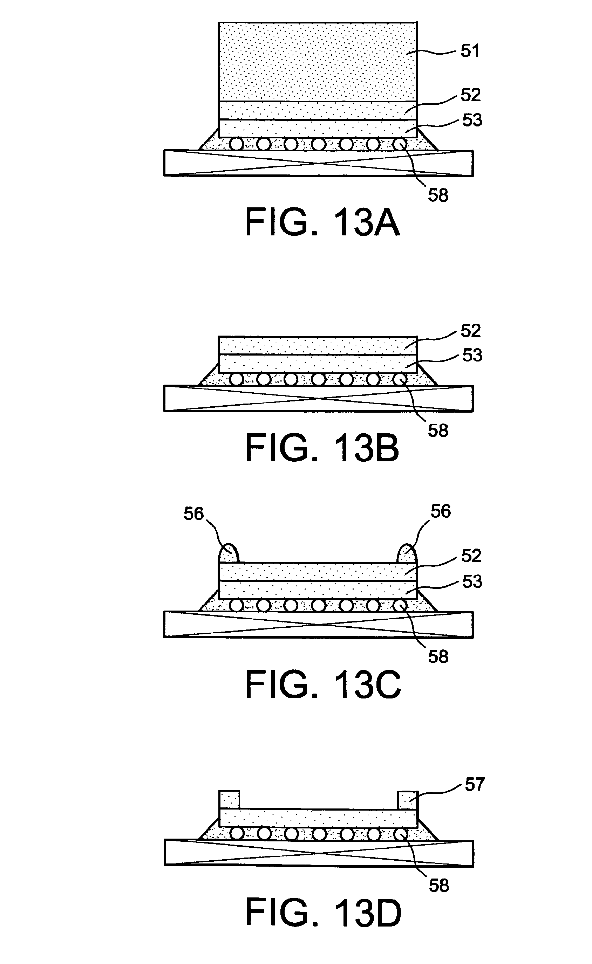

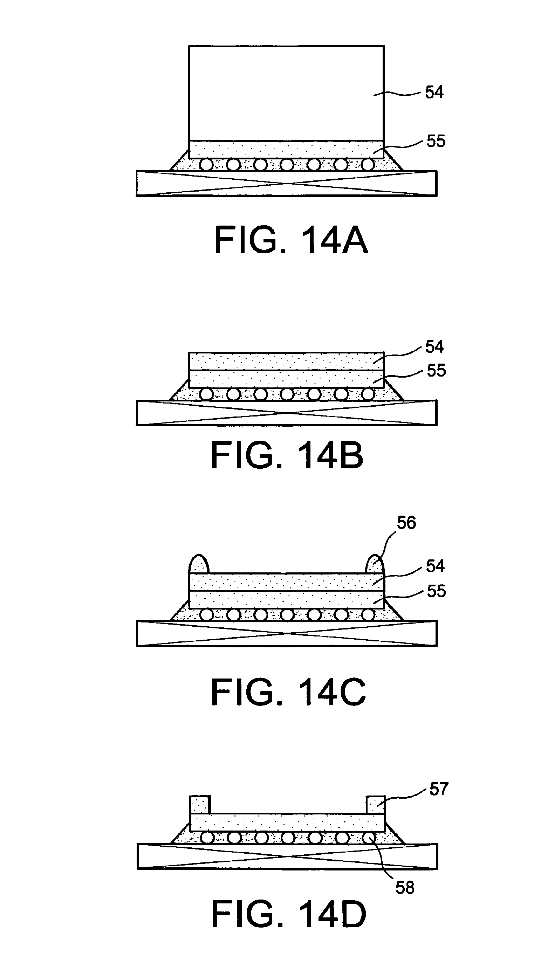

Ce troisième mode de réalisation consiste à exploiter l'architecture du détecteur et du procédé d'amincissement pour réaliser des structures de positionnement intrinsèques au composant. Les figures 13A à 13C illustrent ce mode de réalisation en utilisant un hétéro-substrat (substrat 51 + substrat intermédiaire 52 + partie active 53). Les figures 14A à 14C illustrent ce mode de réalisation en utilisant un homo-substrat (substrat 54 + partie active 55).

L'épitaxie de la couche active 53, par exemple en CdHgTe, d'une matrice de détection infrarouge sur un substrat 51, par exemple Ge, est précédée par la réalisation d'un tampon ou « buffer » (substrat intermédiaire) 52 de croissance nécessaire à l'adaptation de maille cristalline comme illustré sur la figure 13A. Déposé par jets moléculaires, le « buffer » 52 a une épaisseur maîtrisée à +/-0,1 µm.

Dans une étape d'amincissement du détecteur après une étape d'hybridation, le substrat 51 est éliminé par voie chimique sélective sur le « buffer » comme illustré sur la figure 13B. On a ensuite une étape de dépôt d'un cordon de résine périphérique 56, comme illustré sur la figure 13C, avant de passer à une étape d'élimination du « buffer » 52 par une solution sélective sur le matériau de la couche active 53. Lors de l'attaque de ce dernier, on conserve son épaisseur sous le cordon de résine 56, qui est ensuite éliminé par un solvant. On obtient ainsi la structure présentée en figure 13D, constituée du détecteur lui-même (couche active) muni d'une cale périphérique de soutien 57 en CdTe, qui correspond au « buffer » 52. L'épaisseur de « buffer » 52, et donc de la cale 57 peut varier de 1 µm à 50 µm.

On réalise alors une étape de dépôt d'au moins un élément optique 61. La cale de soutien 57 sert donc de butée en Z pour le positionnement de tout élément optique utile au système de détection ou à l'application visée : optiques ou micro-optiques simples ou étagées, obturateurs, caches, objets analysés ou utiles à l'analyse, etc.

Dans le cas d'un composant qui ne permettrait pas l'exploitation d'une chimie sélective, on réalise une étape de polissage maîtrisé quant à son arrêt à une cote prédéterminée, par exemple à +/-2.5 µm. Le procédé est alors celui illustré sur les figures 14A à 14D, dans un exemple d'un composant homo-substrat avec une croissance sur un substrat 54, par exemple en CdZnTe.
La figure 14A illustre le module avant amincissement.
La figure 14B illustre l'étape d'amincissement mécanique et la première étape de gravure chimique.
La figure 14C illustre l'étape de dépôt de résine.
La figure 14D illustre la seconde étape de gravure chimique.

Comme illustré sur la figure 15 on vient ensuite rapporter l'élément optique 61 sur le détecteur 62 avec des billes de maintien 60.

Ce troisième mode de réalisation permet d'obtenir des avantages directs :
- positionnement e en Z de quelques µm a quelques 100 µm avec +/-0.1 µm,
- alignement en X et Y grâce aux billes de maintien 60 avec +/-0.1 µm,
- diminution de la contrainte de poids sur les billes de soutien.

Il permet également d'obtenir des avantages indirects :
- possibilité d'alimenter électriquement l'élément optique,
- possibilité d'herméticité.

### REFERENCES

- [1]: FR 2 646 558
- [2]: FR 2 715 002
- [3]: US 005496769

## Revendications

1. Système détecteur avec fonction optique comprenant :
- un détecteur de rayonnement électromagnétique comportant
• une partie détectrice (21)
• un circuit de lecture (20)
• des billes d'hybridation (23) et un matériau de remplissage formant un bourrelet autour de la partie détectrice pour former des cales de soutien (37, 45, 57) disposés entre cette partie détectrice et ce circuit de lecture,
- un élément optique (35, 49, 61) et,
- un système de positionnement et d'alignement passif de l'élément optique au plus près du détecteur (21) de rayonnement électromagnétique, qui comprend les dits cales de soutien (37, 45, 57) pour un positionnement en Z de l'élément optique (35) au plus près du détecteur, et des moyens d'alignement passif en X, Y par le biais de cales et/ou billes de maintien dits positionnées autour de la partie détectrice (36, 60, 71), les axes X, Y et Z étant trois axes perpendiculaires entre eux.

2. Système selon la revendication 1, dans lequel le détecteur est un détecteur infrarouge refroidi.

3. Système selon la revendication 2, dans lequel l'élément optique est intégré dans un cryostat.

4. Procédé de réalisation d'un système détecteur avec fonction optique comprenant au moins un élément optique (35) et un détecteur (21) de rayonnement électromagnétique comportant un circuit de lecture (20) et une partie détectrice (21) reliés mécaniquement et électriquement au moyen de billes d'hybridation (23) et d'un matériau de remplissage formant un bourrelet (30) sur les cotés de la partie détectrice, **caractérisé en ce qu'**il comprend :
- une étape de formation de cales de soutien (37, 57) pour le positionnement en Z de l'au moins un élément optique (35),
- une étape d'introduction de cales et/ou billes de maintien (36, 60, 71) entre l'au moins un élément optique et le détecteur et autour de la partie détectrice de manière à permettre un alignement passif en X, Y, les axes X, Y et Z étant trois axes perpendiculaires entre eux,
- une étape de positionnement et d'alignement passif de cet au moins élément optique (35) au plus près du détecteur de rayonnement électromagnétique.

5. Procédé selon la revendication 4, qui comprend les étapes suivantes :
- une étape de fabrication d'un bourrelet (30),
- une étape d'amincissement mécanique du détecteur,
- une étape de gravure chimique sélective permettant de créer des cales de soutien (37),
- une étape de fixation de l'au moins un élément optique (35) avec des billes de maintien (36) positionnées autour du détecteur.

6. Procédé selon la revendication 5, dans lequel, au cours de l'étape de fixation de l'au moins un élément optique (35) les billes sont positionnées de façon individuelle ou collective.

7. Procédé selon la revendication 5, dans lequel des billes de maintien (36) servent de lien électrique entre l'élément optique (35) et le circuit de lecture (20).

8. Procédé selon la revendication 4, qui comprend les étapes suivantes :
- une étape de gravure de sillons (44) à la périphérie du détecteur (40),
- une étape de singularisation du détecteur (40),
- une étape d'hybridation du détecteur (40) sur un circuit de lecture (48) par l'intermédiaire de billes d'hybridation (47),
- une étape de dépôt d'un « underfill » (46) entre ces billes d'hybridation (47),
- une étape d'amincissement mécanique du détecteur (40),
- une étape d'amincissement chimique sélectif permettant de créer des cales de maintien (71),
- une étape de fixation de l'élément optique (49).

9. Procédé selon la revendication 8, dans lequel l'étape de fixation de l'élément optique comprend l'introduction de points ou d'un cordon de colle (55).

10. Procédé selon la revendication 4, qui comprend les étapes suivantes :
- une étape d'épitaxie d'une couche active (53) sur un substrat (51) après réalisation d'un « buffer » (52),
- une étape d'hybridation,
- une étape d'amincissement mécanique,
- une première étape de gravure chimique,
- une étape de dépôt d'un cordon de résine périphérique (56),
- une seconde étape de gravure chimique,
- une étape d'élimination du cordon de résine (52) par un solvant permettant d'obtenir une cale périphérique de soutien (57),
- une étape de dépôt d'au moins un élément optique (61) avec des billes de maintien (60).

11. Procédé selon la revendication 10, dans lequel l'étape d'amincissement mécanique est une étape de polissage maîtrisé quant à son arrêt à une côte déterminée.

## Claims

1. A detector system with an optical function comprising:
- an electromagnetic radiation detector including
• a detector portion (21)
• a readout circuit (20)
• hybridization balls (23) and a filling material forming a protruding rim around the detector portion in order to form supporting wedges (37, 45, 57) positioned between this detector portion and this readout circuit,
- an optical component (35, 49, 61), and
- a system for positioning and passively aligning the optical component as close as possible to the electromagnetic radiation detector (21), which comprises said supporting wedges (37, 45, 57) for Z positioning of the optical component (35) as close as possible to the detector, and means for passive alignment in X, Y by means of holding wedges and/or holding balls (36, 60, 71) placed around the detector portion, the axes X, Y and Z being three axes perpendicular to each other.

2. The system according to claim 1, wherein the detector is a cooled infrared detector.

3. The system according to claim 2, wherein the optical component is integrated into a cryostat.

4. A method for making a detector system with an optical function comprising at least one optical component (35) and an electromagnetic radiation detector (21) including a readout circuit (20) and a detector portion (21) mechanically and electrically connected by means of hybridization balls (23) and a filling material forming a protruding rim (30) on the sides of the detector portion, **characterized in that** it comprises:
- a step for forming supporting wedges (37, 57), for Z positioning of said at least one optical component (35),
- a step for introducing holding wedges and/or holding balls (36, 60, 71) between at least one optical component and the detector and around the detector portion so as to allow passive alignment in X, Y, the X, Y and Z axes being three axes perpendicular between each other.
- a step for positioning and passively aligning said at least one optical component (35) as close as possible to the electromagnetic radiation detector.

5. The method according to claim 4, which comprises the following steps:
- a step for making a protruding rim (30),
- a step for mechanically thinning the detector,
- a selective chemical etching step with which supporting wedges may be created (37),
- a step for attaching said at least one optical component (35) with holding balls (36) positioned around the detector.

6. The method according to claim 5, wherein during the step for attaching at least one optical component (35) the balls are positioned individually or collectively.

7. The method according to claim 5, wherein the holding balls (36) provide an electric connection between the optical component (35) and the readout circuit (20).

8. The method according to claim 4, which comprises the following steps:
- a step for etching grooves (44) at the periphery of the detector (40),
- a step for singularizing the detector (40),
- a step for hybridizing the detector (40) on a readout circuit (48) via hybridization balls (47),
- a step for depositing an underfill (46) between these hybridization balls (47),
- a step for mechanically thinning the detector (40),
- a selective chemical thinning step with which holding wedges may be created (71),
- a step for attaching the optical component (49).

9. The method according to claim 8, wherein the step for attaching the optical component comprises the introduction of adhesive drops or seam (55).

10. The method according to claim 4, which comprises the following steps:
- a step for epitaxy of an active layer (53) on a substrate (51) after making a buffer (52),
- a hybridization step,
- a mechanical thinning step,
- a first chemical etching step,
- a step for depositing a peripheral resin seam (56),
- a second chemical etching step,
- a step for removing the resin seam (52) with a solvent for obtaining a peripheral supporting wedge (57),
- a step for depositing at least one optical component (61) with holding balls (60).

11. The method according to claim 10, wherein the mechanical thinning step is a polishing step controlled as regards its stopping at a determined level.

## Patentansprüche

1. Detektor-System mit optischer Funktion, das System umfassend:
- einen Detektor für elektromagnetische Strahlung, welcher aufweist:
* einen Detektionsteil (21)
* eine Lese-Schaltung (20)
* Hybridisierungs-Kugeln (23) und ein Füllmaterial, welches eine Wulst um den Detektionsteil herum bildet zur Schaffung von zwischen diesem Detektionsteil und der Leseschaltung angeordneten Stützkeilen (37, 45, 57),
- ein optisches Element (35, 49, 61), sowie
- ein System zur Positionierung und passiven Ausrichtung des optischen Elements zunächst dem Detektor (2) für die elektromagnetische Strahlung, wobei das System die genannten Stützkeile (37, 45, 57) umfasst für eine Positionierung in Z-Richtung des optischen Elements (35) zunächst dem Detektor, und Mittel zur passiven Ausrichtung in X- und in Y- Richtung durch die Keil-Schrägen und/oder durch um den Detektionsteil herum angeordnete Halterungskugeln (36, 60, 71),
wobei die X-, Y- und Z-Achsen drei zueinander rechtwinkelige Achsen sind.

2. System nach Anspruch 1, bei welchem der Detektor ein gekühlter Infrarot-Detektor ist.

3. System nach Anspruch 2, bei welchem das optische Element in einem Kryostaten integriert ist.

4. Verfahren zur Schaffung eines Detektorsysrems mit optischer Funktion, umfassend wenigstens ein optisches Element (35) und einen Detektor (21) für elektromagnetische Strahlung, welcher eine Lese-Schaltung (20) und ein Detektionsteil (21) aufweist, die mechanisch und elektrisch mittels Hybridisierungskugeln (23) und eines Füllmaterials verbunden sind, das einen Wulst um die Seiten des Detektionsteils bildet, **dadurch gekennzeichnet, dass** das Verfahren umfasst:
- eine Verfahrensstufe bzw. -etappe der Ausbildung von Stützkeilen (37, 57) für die Positionierung des wenigstens einen optischen Elements (35) in Z- Richtung,
- eine Stufe bzw. Etappe der Einbringung von Keilen und/oder Halterungskugeln (36, 60, 71) zwischen dem wenigstens einen optischen Element und dem Detektor und um den Detektionsteil herum solcher Art, dass eine passive Ausrichtung in X- und in Y-Richtung ermöglicht wird, wobei die X-, Y- und Z -Achsen drei zueinander rechtwinkelige Achsen sind.
- eine Stufe bzw. Etappe der Positionierung und passiven Ausrichtung dieses wenigstens einen optischen Elements zunächst dem Detektor für die elektromagnetische Strahlung.

5. Verfahren nach Anspruch 4, welches die folgenden Stufen bzw. Etappen umfaßt:
- eine Stufe bzw. Etappe der Herstellung einer Wulst (30),
- eine Stufe bzw. Etappe mechanischer Dickenverjüngung des Detektors,
- eine Stufe bzw. Etappe einer selektiven chemischen Ätzung zur Schaffung der Stützkeile (37)
- eine Stufe bzw. Etappe der Fixierung des wenigstens einen optischen Elements (35) mit um den Detektor herum positionierten Halterungskugeln (36).

6. Verfahren nach Anspruch 5, bei welchem im Verlauf der Stufe bzw. Etappe der Fixierung des wenigstens einen optischen Elements (35) die Kugeln individuell einzeln oder kollektiv positioniert werden.

7. Verfahren nach Anspruch 5, bei welchem die Halterungskugeln (36) zur elektrischen Verbindung zwischen dem optischen Element (35) und der Lese-Schaltung (20) dienen.

8. Verfahren nach Anspruch 4, welches die folgenden Verfahrensstufen bzw.
- etappen umfasst:
- eine Stufe bzw. Etappe zum Äetzen von Furchen (44) am Umfang des Detektors (40),
- eine Stufe bzw. Etappe der Singularisierung des Detektors (40),
- eine Stufe bzw. Etappe der Hybridisierung des Detektors (40) auf einer Lese-Schaltung (48) mittels Hybridisierungskugeln (47),
- eine Stufe bzw. Etappe der Abscheidung einer 'Füllung' (46) zwischen diesen Hybridisierungskugeln (47),
- eine Stufe bzw. Etappe der mechanischen Dickenverjüngung des Detektors (40),
- eine Stufe bzw. Etappe der selektiven chemischen Dickenverjüngung zur Bildung der Halterungskeile (71),
- eine Stufe bzw. Etappe der Fixierung des optischen Elements (49).

9. Verfahren nach Anspruch 8, bei welchem die Stufe der Fixierung des optischen Elements die Einbringung von Spitzen oder eines Cordons (55) aus Kleber umfaßt.

10. Verfahren nach Anspruch 4, das die folgenden Stufen bzw. Etappen umfasst:
- eine Stufe zur Epitaxial-Erzeugung einer aktiven Schicht (53) auf einem Substrat (51) nach Herstellen eines 'Puffers' (52),
- eine Hybridisierungsstufe ,
- eine Stufe zur mechanischen Dickenverjüngung ,
- eine erste chemische Ätzstufe ,
- eine Stufe zur Abscheidung eines Umfangscordons (56) aus einem Kunstharz,
- eine zweite chemische Ätzstufe,
- eine Stufe der Beseitigung des Kunstharz-Cordons (52) mittels eines Lösungsmittels, zur Schaffung eines Umfangs-Stützkeils (57),
- eine Stufe der Abscheidung wenigstens eines optischen Elements (61) mit Halterungskugeln (60).

11. Verfahren nach Anspruch 10, bei welchem die Stufe der mechanischen Dickenverjüngung eine hinsichtlich ihrem Stopp bei einem vorgegebenen Wert kontrollierte Polierstufe ist.
